# EUROPEAN PATENT APPLICATION

(11) **EP 4 823 269 A1**
(43) Date of publication of application: **14.10.2026**
(21) Application number: 25168751.3
(22) Date of filing: 07.04.2025
(51) Int. Cl.: H10B 43/27, H10D 64/01

(54) **A METHOD FOR FORMING A MEMORY STRUCTURE FOR A 3D NAND FLASH MEMORY**

(71) Applicant: IMEC VZW, 3001 Leuven (BE)
(72) Inventor: RACHIDI, Sana, 3000 Leuven (BE); ROSMEULEN, Maarten, 9000 Gent (BE); ARMINI, Silvia, 3001 Heverlee (BE); VAN DEN BOSCH, Geert, 3010 Kessel-Lo (BE)
(74) Representative: Lind Edlund Kenamets Intellectual Property AB

(57) **Abstract**

A method for forming a memory structure for a 3D NAND flash memory, the method comprising:
forming a layer stack over a substrate, the layer stack comprising an alternating sequence of gate layers and inter-gate spacer layers;
forming recessed areas in a sidewall surrounding a memory hole in the layer stack by laterally etching back the gate layers relative to the inter-gate spacer layers from the memory hole;
forming a discrete blocking oxide layer in each recessed area, wherein a thickness of each blocking oxide layer in a lateral direction is less than a depth of each recessed area in the lateral direction;
conformally depositing a continuous liner layer on exposed surfaces in the memory hole, wherein the liner layer covers the blocking oxide layer in each recessed area;
depositing a continuous sacrificial layer on the liner layer;
etching back the sacrificial layer such that the liner layer is exposed outside the recessed areas and discrete portions of the sacrificial layer remain in the recessed areas;
removing exposed portions of the liner layer while using the discrete sacrificial layer portions as an etch mask such that discrete portions of the liner layer covered by the discrete sacrificial layer portions remain in the recessed areas;
removing the discrete portions of the sacrificial layer in the recessed areas;
forming a discrete charge trap layer in each recessed area, wherein each charge trap layer is deposited on the discrete liner layer portion remaining in each recessed area by a first area-selective deposition process while using the discrete liner layer portion as a seeding layer;
subsequent to forming the charge trap layers, depositing a tunneling oxide layer in the memory hole; and
depositing a channel layer on the tunneling oxide layer.

## Description

### TECHNICAL FIELD

The present invention generally relates to a method for forming a memory structure for a 3D NAND flash memory.

### BACKGROUND

The bit density in the 3D NAND flash memory road map increases every year. This far, the increase has been enabled by increasing the number of stacked memory cells along the vertical dimension. However, this route is becoming increasingly difficult and costly. Hence, there is increasing interest in techniques for scaling the cells along the vertical dimension. Vertical scaling ("z-pitch scaling") is achieved by reducing the thickness of the layers in the layer stack, e.g. the word line (gate) layers and oxide inter-gate spacer layers.

Current 3D NAND technology is often based on the so-called charge trap cell utilizing a charge trap layer (e.g. of SiN) as a storage layer. Traditionally, the charge trap layer has been deposited as a continuous layer along the sidewall of the memory hole in the layer stack. Z-scaling results in a reduced inter-cell separation which in turn may reduce the retention performance of the continuous charge trap layer. There is hence a need for scalable techniques allowing forming of an interrupted charge trap layer such that each memory cell may be provided with a separate charge trap layer.

### SUMMARY

It is an object of the present invention to provide a method for forming a memory structure suitable for a 3D NAND flash memory, allowing reliable forming of an interrupted / cut charge trap layer also at aggressive z-pitch scaling.

Hence, according to an aspect of the present invention, there is provided a method for forming a memory structure for a 3D NAND flash memory, the method comprising:
forming a layer stack over a substrate, the layer stack comprising an alternating sequence of gate layers and inter-gate spacer layers;
forming recessed areas in a sidewall surrounding a memory hole in the layer stack by laterally etching back the gate layers relative to the inter-gate spacer layers from the memory hole;
forming a discrete blocking oxide layer in each recessed area, wherein a thickness of each blocking oxide layer in a lateral direction is less than a depth of each recessed area in the lateral direction;
conformally depositing a continuous liner layer on exposed surfaces in the memory hole, wherein the liner layer covers the blocking oxide layer in each recessed area;
depositing a continuous sacrificial layer on the liner layer;
etching back the sacrificial layer such that the liner layer is exposed outside the recessed areas and discrete portions of the sacrificial layer remain in the recessed areas;
removing exposed portions of the liner layer while using the discrete sacrificial layer portions as an etch mask such that discrete portions of the liner layer covered by the discrete sacrificial layer portions remain in the recessed areas;
removing the discrete portions of the sacrificial layer in the recessed areas;
forming a discrete charge trap layer in each recessed area, wherein each charge trap layer is deposited on the discrete liner layer portion remaining in each recessed area by a (first) area-selective deposition process while using the discrete liner layer portion as a seeding layer;
subsequent to forming the charge trap layers, depositing a tunneling oxide layer in the memory hole; and
depositing a channel layer on the tunneling oxide layer.

Thus, the method according to the present aspect enables forming of a memory structure comprising vertically separated lateral memory stacks, each comprising a respective discrete blocking oxide layer and a respective discrete charge trap layer for each gate layer or, equivalently, for each memory cell.

Rather than depositing a continuous charge trap layer and subsequently "cutting" the charge trap layer into a number of discrete portions by etching, the method "directly" deposits the discrete charge trap layers using an area selective deposition process (ASD), wherein the (discrete) liner layer portions in the recessed areas are used to define seeding (deposition-promoting) areas ("growth areas") for the charge trap material of the charge trap layers. Deposition of the charge trap material in areas vertically between the gate layers may hence be avoided (i.e., on end surfaces of the inter-gate spacer layers facing the memory hole), thus obviating the need for cutting a continuous layer of charge trap material by etching. By obviating the need for cutting the charge trap material by etching, the lateral thickness of the charge trap layers (i.e., the thickness dimension as seen along the lateral direction) may be precisely controlled by maintaining the growth conditions of the selective deposition until a target thickness has been achieved.

A common material choice for the inter-gate spacer layers is an oxide (typically silicon oxide). Therefore, it is envisaged that ASD of charge trap material on the blocking oxide layers in the recessed areas without any appreciable concurrent deposition on the inter-gate spacer layers would be challenging. However, by the conformal deposition of a continuous liner layer, followed by deposition and etch back of a sacrificial layer, discrete liner layer portions configured as seeding layers for the ASD of charge trap material may be formed in a reliable manner within the recessed areas. Thereby, charge trap material may be deposited with a considerably improved area selectivity. That is, the discrete liner layer portions may be localized to the recessed areas and be formed of a material selected to facilitate the ASD of the charge trap material.

In some embodiments, the discrete blocking oxide layer is deposited on the etched-back gate layer in each recessed area by a (second) area-selective deposition process.

Hence, the blocking oxide material of the blocking oxide layers may, like the charge trap material, be deposited by ASD. During the ASD of the blocking oxide material, the gate layers may define deposition-promoting (seeding) areas contributing to a preferential deposition of the blocking oxide material in the recessed areas.

In some embodiments, the discrete blocking oxide layer is formed by oxidizing a portion of the etched-back gate layer in each recessed area, such that the oxidized portion forms the discrete blocking oxide layer on a non-oxidized portion of the etched-back gate layer.

This may facilitate forming of the discrete blocking oxide layers in an area-selective manner, within the recessed areas. In particular, discrete blocking oxide layers may be formed also in cases where the materials of the gate layers and the inter-gate spacer layers provide limited contrast for ASD. This approach may be used where the gate layers are formed of a material that may be oxidized into a species of oxide suitable as a blocking oxide, such as silicon oxide. The gate layers may be formed of a silicon-comprising material, for instance silicon nitride, amorphous silicon (a-Si) or polysilicon.

In some embodiments, the portions of the etched-back gate layer are oxidized by a thermal oxidation process.

The blocking oxide layers may thus be formed using a simple, reliable and cost-effective process which further may be relatively benign to non-targeted layers, such as the inter-gate spacer layers. A thermal oxidation process may also facilitate a reliable oxidation in high-aspect ratio structures.

In some embodiments, the portions of the etched-back gate layer are oxidized by a plasma oxidation process.

In some embodiments, the liner layer comprises a metal oxide or a metal nitride. Such liner/seeding layer materials (e.g., aluminum oxide, hafnium oxide, titanium oxide or titanium nitride) facilitate process control as they may define efficient deposition-promoting surfaces with respect to ASD of the charge trap material, notably relative to non-metal oxide or non-metal nitride (typically silicon oxide) inter-gate spacer layers. Further metal oxides or metal nitrides may be reliably deposited as continuous and conformal layers, e.g., using atomic layer deposition (ALD).

In some embodiments, the sacrificial layer is deposited to completely fill a remaining space in each recessed area. This may improve process control by providing an additional margin against over-etching during etching back the sacrificial layer. Thus, this makes it easier to ensure that discrete portions of the sacrificial layer remain to cover the liner layer in the recessed areas after completing the etch back.

In some embodiments, the charge trap layers are silicon-comprising layer, such as silicon nitride layers. Silicon-comprising layers are suitable for charge trap layers. Silicon nitride in particular represents an efficient and rational realization of charge trap-based memory cells. Further, silicon nitride is suitable for ASD onto conformal metal oxides or metal nitrides, without causing any appreciable co-deposition onto silicon oxide.

In some embodiments, the gate layers are silicon-comprising layers, such as silicon nitride layers, a-Si layers, or polysilicon layers. Such layers allow final functional gates to be formed in a replacement metal gate (RMG) process. Polysilicon gate layers (e.g., when highly doped) may also be used as functional gates in the final devices.

In some embodiments, the gate layers are sacrificial gate layers and the method further comprises, subsequent to forming the charge trap layers, replacing the sacrificial gate layers by a replacement metal gate layer. The sacrificial gate layers may thus be replaced with functional metal gate layers by an RMG process. The sacrificial gate layers may be removed by etching back the sacrificial gate layers from a second hole (e.g., an "access trench") in the layer stack, different from the memory hole, and subsequently forming RMG layers replacing the sacrificial gate layers. The RMG layers may conveniently be formed subsequent to depositing the tunneling oxide layer and the channel layer.

### BRIEF DESCRIPTION OF THE DRAWINGS

The above, as well as additional objects, embodiments, features and effects of the present invention, may be better understood through the following illustrative and non-limiting detailed description, with reference to the appended drawings. In the drawings like reference numerals will be used for like elements unless stated otherwise.
Fig. 1a-b schematically shows a schematic cross-sectional view, and a top-down view, respectively, of a starting structure for forming a memory structure according to an embodiment.
Fig. 2 shows the structure after forming recessed areas.
Fig. 3 shows the structure after forming blocking oxide layers in the recessed areas.
Fig. 4 shows the structure after depositing a continuous conformal liner layer.
Fig. 5 shows the structure after depositing sacrificial layer on the liner layer.
Fig. 6 shows the structure after etching back the sacrificial layer.
Fig. 7 shows the structure after etching back the liner layer.
Fig. 8 shows the structure after removing sacrificial layer portions from the recessed areas.
Fig. 9 shows the structure after growing charge trap layers in the recessed areas.
Fig. 10 shows the structure after forming tunnel barrier and channel layers.
Fig. 11 shows the structure after a replacement metal gate process.
Fig. 12-13 shows an alternative approach for forming blocking oxide layers in the recessed areas.

### DETAILED DESCRIPTION

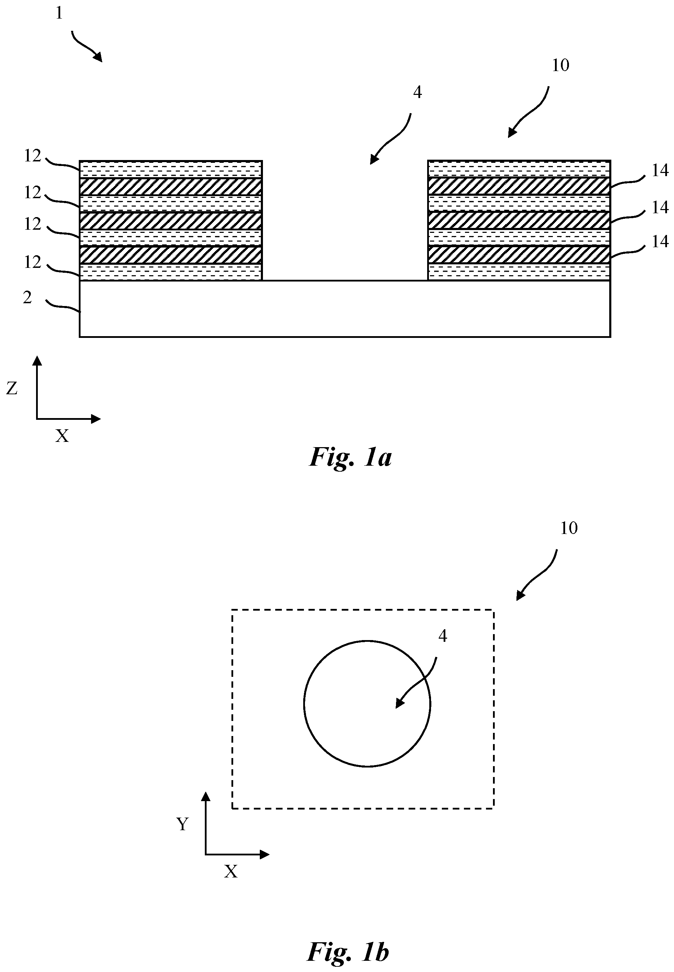

Embodiments of a method for forming a memory structure for a 3D NAND flash memory, such as a 3D-Gate-All-Around-NAND (3D GAA NAND), will now be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a supporting substrate of the memory structure. A lateral/horizontal direction may also be understood as a direction parallel to an in-plane direction of the gate and inter-gate spacer layers. The term "vertical" refers to a direction parallel to a normal direction to (the main surface of) the substrate, i.e. transverse to the substrate. Reference is herein also made to a "radial" direction. This term is to be understood as a radial direction with respect to a given memory hole (e.g., the memory hole 4 in Fig. 1a), parallel to the horizontal XY-plane. The terms "radially inward" and "radially outward" accordingly refers to radially inward and outward directions, respectively, with respect to a given memory hole. Related terms, such as "radially inner", "radially and "radially outer" may correspondingly be used to indicate a relative radial location or distance of a feature or element, relative to the given memory hole.

Fig. 1a-b schematically shows a schematic cross-sectional view, and a top-down view, respectively, of a structure 1 at an initial stage of the method. The structure 1 comprises a layer stack 10 representing a precursor or starting structure for the memory structure, to be subjected to the processing steps of the method disclosed in the following.

The layer stack 10 is formed over a substrate 2 and comprises an alternating sequence of gate layers 14 and inter-gate spacer layers 12. The inter-gate spacer layers 12 and the gate layers 14 are stacked on top of each other along the vertical direction Z.

The substrate 2 may be a conventional substrate, suitable for semiconductor processing and for supporting a memory structure for a 3D NAND flash memory. The substrate 2 may for instance be a Si substrate, a Ge substrate or a SiGe substrate. Other examples include a silicon-on-insulator (SOI) substrate, a GeOI substrate or a SiGeOI substrate.

The gate layers 14 may be silicon-comprising layers, such as SiN layers, a-Si layers or polysilicon layers, thus forming sacrificial gate layers 14 intended to be replaced by an RMG stack in subsequent process steps. The gate layers 14 may also be functional gate layers, e.g. highly doped polysilicon-comprising layers.

The inter-gate spacer layers 12 may be oxide-comprising layers, typically silicon oxide (e.g., SiO₂) layers or another suitable inter-layer dielectric (e.g. of low-k). The inter-gate spacer layers 12 are arranged in the layer stack 10 to provide vertical separation between the memory cells / word lines of the memory device which is to be formed.

The layer stack 10 may be formed by interchangeably depositing layers of gate material (e.g. nitride) and inter-gate spacer material (e.g. oxide) using deposition processes which per se are known in the art, such as chemical vapor deposition (CVD), physical vapor deposition (PVD) or atomic layer deposition (ALD).

The inter-gate spacer layer 12 and the gate layers 14 may be formed in numbers in accordance with the intended number of stacked memory cells of the memory device. It is to be noted that the number of layers 12, 14 of the illustrated layer stack 10 merely is a non-limiting example and that the method disclosed herein is compatible with stacks of memory cells of essentially any number currently used, or contemplated, in the industry, such as 64, 128, 256 or greater.

The inter-gate spacer layers 12 and the gate layers 14 may each be formed with a respective layer thickness in a range of 5-25 nm, as an example. A z-pitch of the layer stack 10 (i.e. the combined thickness of one inter-gate spacer layer and one gate layer 14) may be in a range from about 45 nm to 15 nm or less.

While omitted for ease of illustration, the layer stack 10 may optionally be capped by a capping layer, for instance a semiconductor layer (e.g., silicon), deposited on top of the top-most inter-gate spacer layer 12. A capping layer may serve to protect the top-most inter-gate spacer layer 12 during the following processing.

After depositing the layers 12 and 14 (and optionally a capping layer) of the layer stack 10, a memory hole 4 may be patterned in the layer stack 10, e.g. by a lithography and etching process. While Fig. 1a-b shows a portion of the layer stack 10 surrounding a single memory hole 4, it is noted that a corresponding memory hole 4 may be patterned at each location where a respective vertical string of memory cells is desired. The memory hole 4 may as shown be formed to extend through each one of the inter-gate spacer layers 12 and gate layers 14 of the layer stack 10. The memory hole 4 may as further shown in the top-down view of Fig. 1b be formed with a circular cross-sectional shape, such that the memory hole 4 may be formed with a substantially circular cylindrical shape (footprint). However, the memory hole 4 may also be formed with other cross-sectional shapes, such as an oval or polygonal shape.

While not shown in Fig. 1a, the layer stack 10 may as per se is known in the art further comprise, underneath the layers 12, 14, a sub-stack of a select layer and a source layer for forming a select plate and a source plate, respectively, of the memory device. The select and source layers may hence form a bottom sub-stack of the layer stack 10. The select and source layers may be formed by conventional techniques and materials, e.g. doped semiconductor layers (e.g. polysilicon), and be separated by layers of interlayer dielectric.

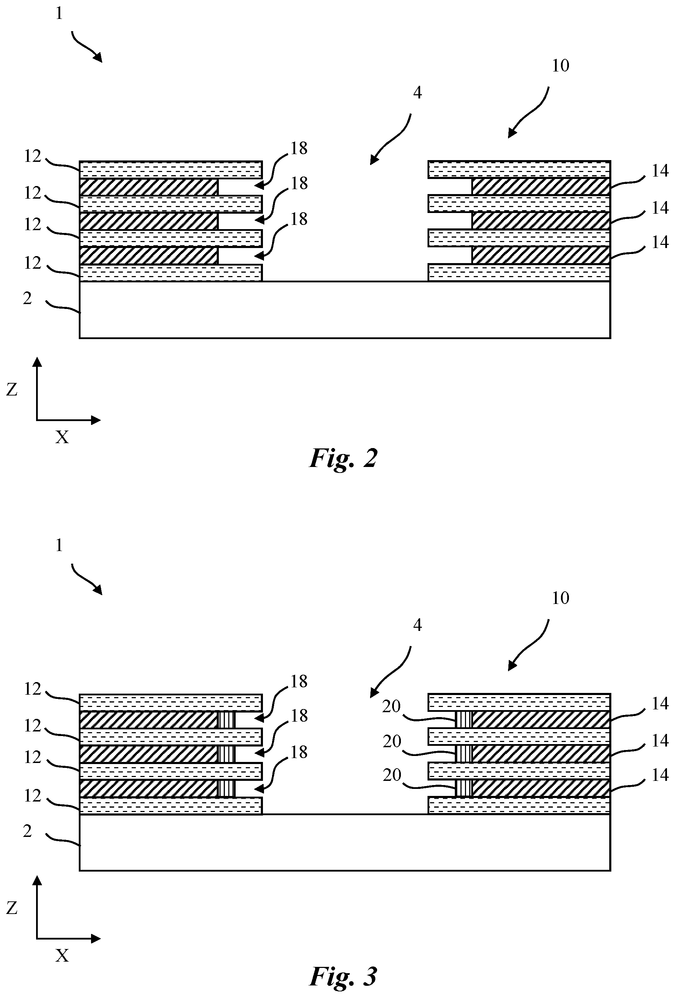

In Fig. 2, recessed areas 18 have been formed in a sidewall of the layer stack 10 surrounding the memory hole 4 by laterally etching back (i.e., in a radially outward direction, along the X-axis) the gate layers 14 relative to the inter-gate spacer layers 12 from the memory hole 4. Thereby, each recessed area / recess 18 is formed between a pair of inter-gate spacer layers 12. Due to the circumferential extension of the sidewall about the memory hole 4, the recessed areas 18 may extend circumferentially about the memory hole 4. In the example of a circular memory hole 4, the recessed areas 18 may be annular.

The gate layers 14 may be etched back using an etching process adapted to etch the gate layers 14 selectively to the inter-gate spacer layers 12. That is, the etching process may be adapted to etch (i.e. remove) the material (e.g. the silicon nitride, a-Si or polysilicon) of the gate layers 14 selectively to the material (e.g. the oxide material) of the gate layers 14, such that the gate layers 14 may be laterally etched back without causing any substantial etchback of the inter-gate spacer layers 12. The etching process may be applied to the sidewall of the layer stack 10 via the memory hole 4. The etching process may be an isotropic etching process. However, any suitably selective etching process, wet or dry, providing a sufficient lateral etching component for the gate layers 14 may be used.

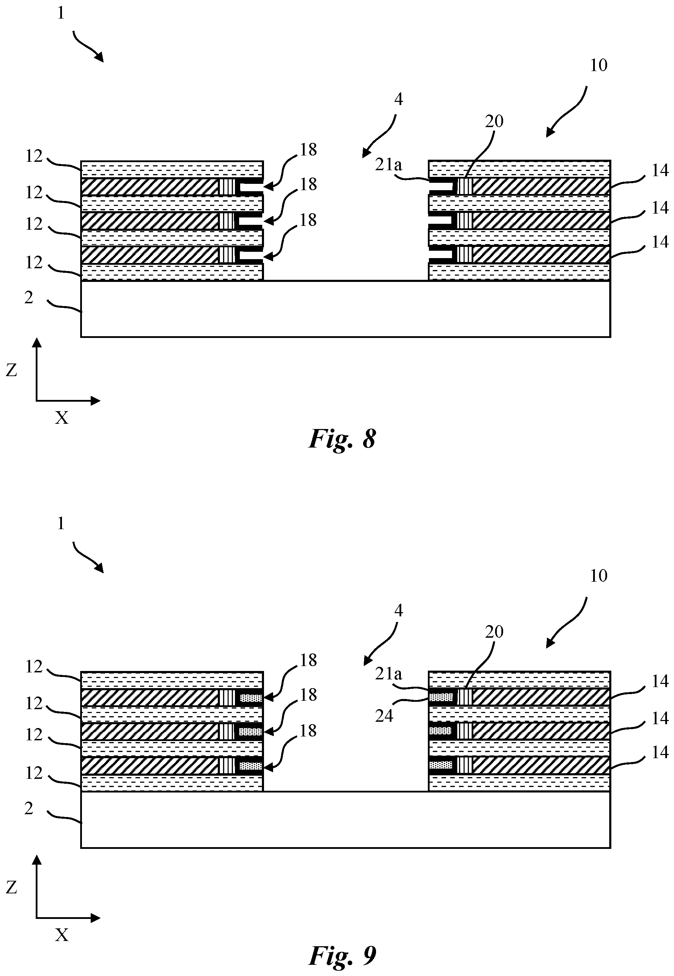

The recessed areas 18 may be formed with a lateral/radial depth (along the X-axis) meeting or exceeding an intended lateral thickness of the lateral memory stacks, e.g., a combined lateral thickness of the blocking oxide and charge trap layers at each gate-level (Fig. 9). As may be appreciated, the lateral depth of the recessed areas 18 is determined by the lateral depth (radial extent) of the lateral etch back. The lateral depth of the recessed areas 18 may for example be in a range of 6-20 nm. The depth of the recessed areas 18 may be controlled by timing the lateral etch back.

In Fig. 3, a discrete blocking oxide layer 20 has been formed in each recessed area 18. The blocking oxide layers 20 are as shown formed with a thickness in the X direction being less than the lateral depth of the recessed areas 18. Thus, each (discrete) blocking oxide layer 20 only partially fills a lateral depth of a respective recessed area 18. Hence, also subsequent to forming the blocking oxide layers 20, the sidewall of the memory hole 4 defines a recessed / profiled sidewall. The discrete blocking oxide layer 20 in each recessed area 18 may for example be formed with a lateral thickness in a range of 4-15 nm. The blocking oxide 24 may comprise or be silicon oxide (SiO₂), or some other oxide material suitable to be used as a blocking oxide.

Discrete blocking oxide layers 20 may be formed by various approaches. According to one approach, discrete blocking oxide layers 20 may be deposited on the etched-back gate layer 14 in each recessed area 18 by an ASD process. Thus, a blocking oxide material for forming the blocking oxide layers 20 may be deposited selectively in the recessed areas 18. The deposition may be continued until discrete portions of blocking oxide material of a target thickness has been deposited in each recessed area 18, each portion defining a respective discrete blocking oxide layer 20. During the ASD, the etched-back end surfaces of the gate layers 14 facing the memory hole 4 may define deposition-promoting (seeding) areas for the blocking oxide material while the inter-gate spacer layers 12 define deposition-inhibiting (non-growth) areas.

The blocking oxide material may be deposited using any suitable deposition process (e.g. an ALD or CVD process) facilitating ASD of the blocking oxide material (e.g. SiO₂) in the recessed areas 18.

To facilitate ASD of the blocking oxide layers 20, the layer stack 10 may be subjected to a treatment process prior to depositing the blocking oxide material, to define growth areas in the recessed areas 18 (e.g., on the end surfaces of the etched-back gate layers 14) and non-growth areas outside the recessed areas 18. The treatment process may be adapted to functionalize the surface portions / end surfaces of the etched-back gate layers 14 in the recessed areas 18 with respect to the ASD of the blocking oxide material. The treatment process may additionally or alternatively be adapted to passivate exposed surface portions of the inter-gate spacer layers 12 with respect to the ASD of the blocking oxide material. Thereafter the blocking oxide material may be deposited selectively in the growth areas in the recessed areas 18. For instance, the functionalization may comprise depositing a deposition-promoting layer on the end surfaces of the etched-back gate layers 14 in the recessed areas 18. Additionally or alternatively, the layer stack 10 may be subjected to a treatment process adapted to passivate exposed surface portions of the inter-gate spacer layers 12 with respect to the ASD of the blocking oxide material 20. For instance, some deposition processes favor deposition on hydrogen terminated surfaces (e.g. the deposition process deposits material preferentially on hydrogen terminated surfaces). A treatment process may hence be adapted to increase an occurrence of hydrogen terminated bonds on the gate layers 14 (thus promoting deposition thereon) and/or reduce an occurrence of hydrogen terminated bonds on the inter-gate spacer layers 12 (thus inhibiting deposition thereon). As a further example, silicon oxide (SiO₂) inter-gate spacer layers 12 can be passivated selectively to silicon nitride/a-Si/polysilicon gate layers 14 using siloxanes, aminosilanes, trichlorosilanes, small molecule inhibitors (SMIs, such as dimethylamino-trimethylsilane (DMA-TMS), trimethyltrimethoxysilane, trimethoxytrichlorosilane, etc.) or self-assembled monolayers (SAMs, such as alkylsilanes), to allow ASD of the blocking oxide material on the end surfaces of the gate layers 14.

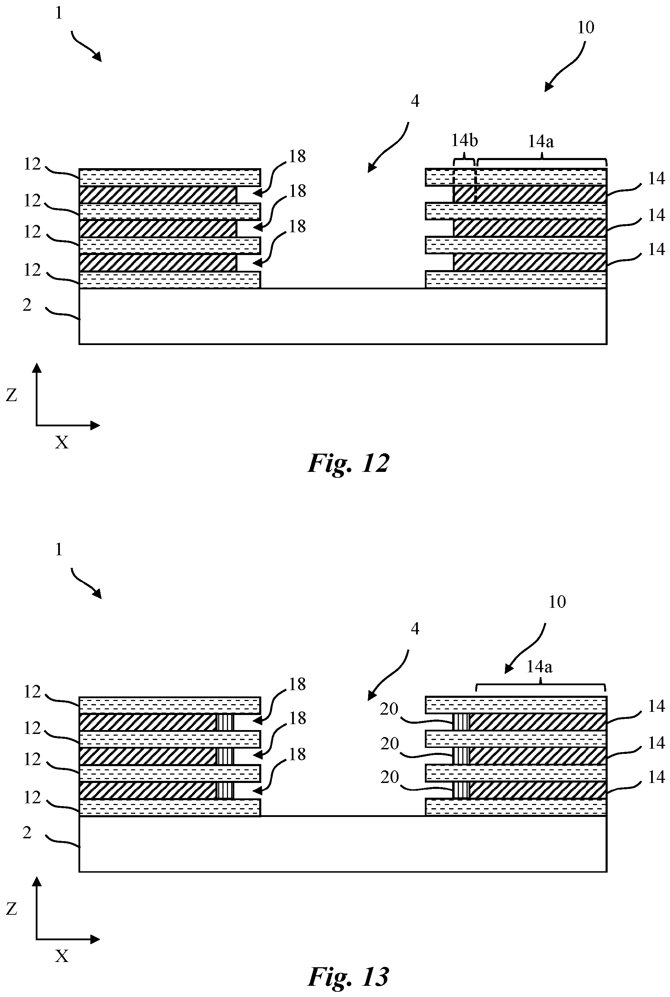

According to another approach, discrete blocking oxide layers 20 may instead be formed by oxidizing portions of the etched-back gate layers 14 in the recessed areas 18. This is schematically illustrated in Fig. 12-13 showing that each blocking oxide layer 20 may be formed by oxidizing a portion 14b of an etched-back gate layer 14 in a respective recessed area 18, wherein the oxidized portion 14b forms the discrete blocking oxide layer 20 on a remaining non-oxidized portion 14a of the gate layer 14. The etched-back gate layers 14 may be exposed to the oxidizing ambient / agent via the memory hole 4. Where the gate layers 14 are silicon-comprising layers, such as silicon nitride layers, a-Si layers, or polysilicon layers, the blocking oxide layers 20 may be formed as silicon oxide (SiO₂) layers. The oxidation process may for example be a thermal oxidation process. The oxide may be a low-temperature oxide (LTO) or a high-temperature oxide (HTO). The oxidation process may also be a plasma oxidation process. An oxidation-based approach discussed above, may be useful to apply to material combinations for which it is challenging to achieve a sufficiently selective deposition of blocking oxide material on the gate layers 14, such as when the inter-gate spacer layers 12 comprise SiO₂.

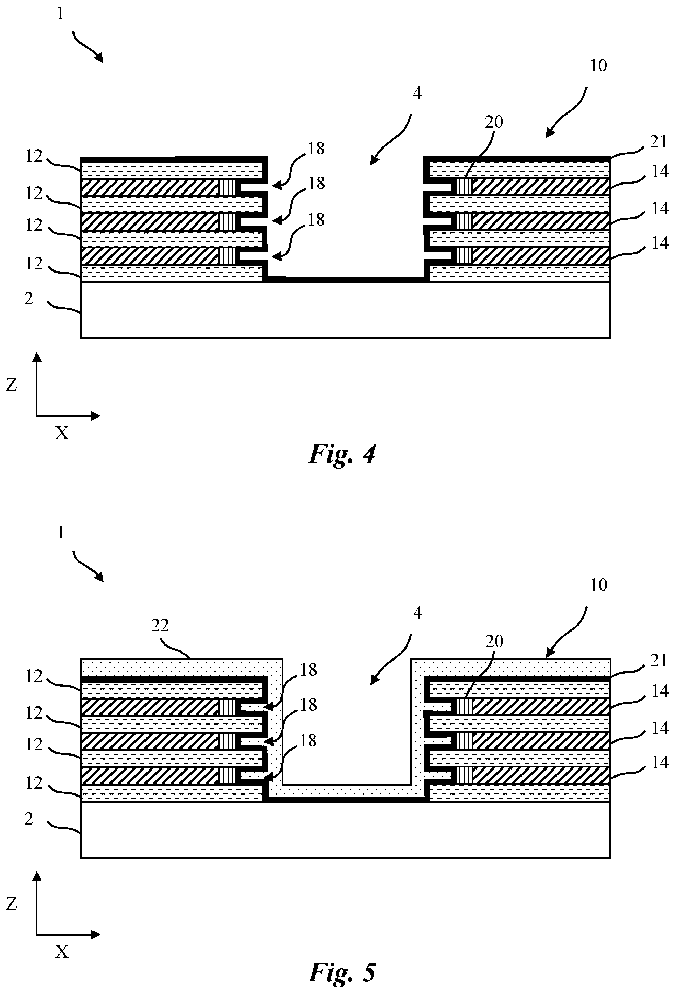

Fig. 4 depicts the structure 1 at a stage after forming the blocking oxide layers 20 (e.g., in accordance with either of the above-discussed approaches) and subsequent to further conformally depositing a continuous liner layer 21 on exposed surfaces in the memory hole 4. The liner layer 21 thus covers (e.g., coats or lines) exposed surface portions of the layer stack 10 facing the memory hole 4. Due to the conformal nature of the deposition, the liner layer 21 covers interior surfaces of the recessed areas 18, including the blocking oxide layer 20 in each recessed area 18. As shown in Fig. 4, the interior surfaces of the recessed areas 18 further include surface portions of the inter-gate spacer layers 12 above and below each recessed area 18. The liner layer 21 may be deposited by ALD, or some other suitable conformal deposition process.

The liner layer 21 is to function as a seeding layer during a subsequent ASD step of charge trap material for forming charge trap layers 24 in the recessed areas 18. Hence, the liner layer 21 may be formed of any material that may be conformally deposited and act as a seeding layer for the ASD of the charge trap material. The liner layer 21 may for example comprise, or be formed of, a metal oxide or a metal nitride, such as AlOₓ, HfOₓ, TiN, TiO₂, or some other high-k oxide or nitride.

Since the recessed areas 18 are further to accommodate the charge trap layers 24 of some minimum target thickness, the liner layer 21 is as shown deposited to only partially fill the recessed areas 18. Thus, the liner layer 21 is formed with a thickness which is smaller than a remaining lateral depth (along the X axis) of the recessed areas 18 being partially filled with the blocking oxide layers 10. Further, the thickness of the liner layer 21 is such that pinch-off of the recessed areas 18 is avoided. The thickness here refers to a local thickness of the liner layer 21, i.e., a thickness of the liner layer 21 measured in a direction normal to its underlying/supporting surface at the location where the local thickness is measured. To avoid pinch-off, a thickness of the liner layer 18 should be less than half a thickness (along the Z-axis) of each gate layer 14, such as at most a third or a quarter of the thickness of each gate layer 14, or less. For instance, the liner layer 18 may be formed with a thickness of about 2 nm or less, such as about 1 nm. A thickness in this range is compatible with the above-mentioned thickness ranges of the gate layers 14 and the blocking oxide layers 20, and the depth range of the recessed areas 18.

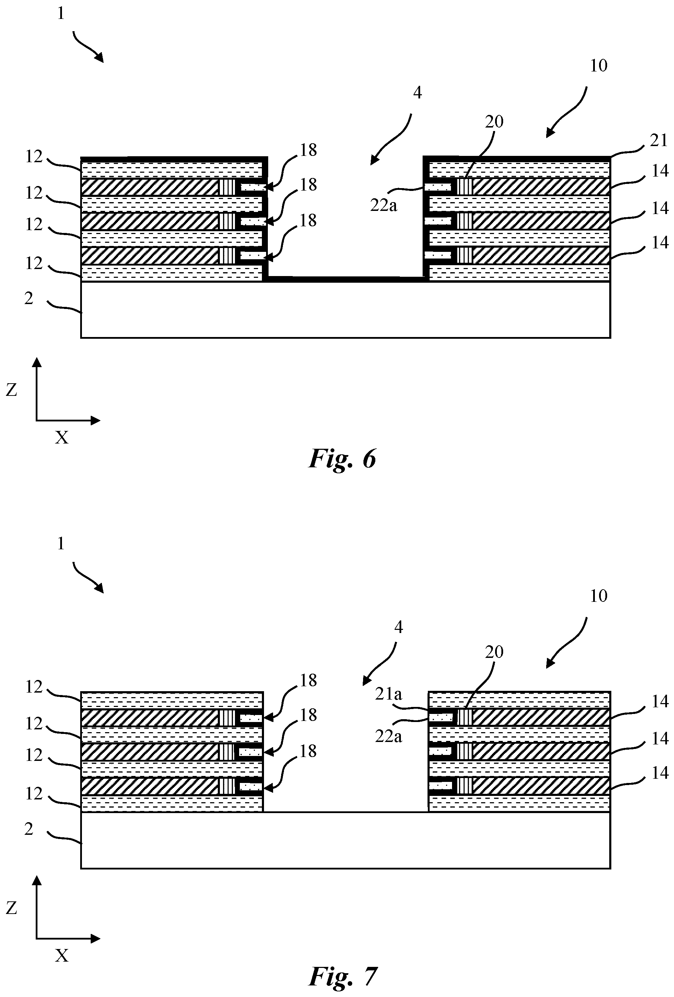

In Fig. 5, a continuous sacrificial layer 22 has been deposited on the liner layer 21, including on portions of the liner layer 21 in the remaining interior spaces of the recessed areas 18. Notably, the sacrificial layer 22 may as shown be deposited to completely fill a remaining interior space of (within) each recessed area 18. The benefit of this may be appreciated from Fig. 6-7: In Fig. 6, the sacrificial layer 22 has been etched back such that the liner layer 21 is exposed outside the recessed areas 18 and discrete portions 22a of the sacrificial layer 22 remain in the recessed areas 18. In Fig. 7, exposed portions of the liner layer 21 (i.e., the portions of the liner layer 21 not covered by the discrete sacrificial layer portions 22a) have been removed while using the discrete sacrificial layer portions 22a (i.e., the remaining discrete portions of the etched-back sacrificial layer 22) as an etch mask such that discrete portions 21a of the liner layer 21 covered by the discrete sacrificial layer portions 22a remain in the recessed areas 18. Thus, by having the sacrificial layer 22 completely filling the remaining interior spaces of the recessed areas 18, it may be ensured that a discrete sacrificial layer portion 22a remains to cover the liner layer 21 in each recessed area 18, upon exposing portions of the liner layer 21 outside of the recessed areas 18.

While a complete filling of the remaining interior spaces of the recessed areas 18 by the sacrificial layer 22 may contribute to process reliability, it is contemplated that a sufficient criterion is that the sacrificial layer 22 fills the remaining interior spaces of the recessed areas 18 to such an extent that, after the etching back of the sacrificial layer 22, discrete sacrificial layer portions 22a are preserved in the recessed areas 18 to such an extent that they may act as an etch mask for the liner layer 21. Thus, in any case, by forming the discrete sacrificial layer portions 21a in the recessed areas 18, discrete liner layer portions 21a may be preserved after the subsequent etch back of the liner layer 21.

In Fig. 7, the etch back of the sacrificial layer 22 is schematically depicted to restore a sidewall of the memory hole 4 to a substantially straight profile. However, this is not a requirement for the functioning of the process. Rather, it is sufficient that a portion of the liner layer 21 in each recessed area 18, in particular the portion extending along the end surface of the gate layer 14 associated with the recessed area 18, is covered by a discrete sacrificial layer portion 22a, such that it may be masked and preserved during the subsequent etch back of the liner layer 21. Thus, a slight lateral over etching of the sacrificial layer portions 22a into the recessed areas 18 need not reduce process yield.

As the sacrificial layer 22 is to serve as an etch mask during etch back of the liner layer 21, the sacrificial layer 22 may in general be formed of any sacrificial material that may be deposited to reliably fill the remaining interior spaces of the recessed areas 18, and that may provide a sufficient etch contrast with respect to the liner layer 21 such that it may be used as an etch mask for the liner layer 21, and that eventually may be removed from the inter-gate spacer layers 12 without causing collateral damage to the structure 1. Examples of sacrificial materials include semiconductors, metals, polymers or insulators. For example, the sacrificial material may be Si, SiN, SiCN, TiN (if not used for the liner layer 21), W (if the liner is TiN) or Mo, to name a few non-limiting examples.

The sacrificial layer 22 may be deposited by conformal, as well as non-conformal deposition processes, as long as the deposition process allows sacrificial material to be deposited to fill the recessed areas 18. Non-limiting examples include CVD, ALD as well as spin-on deposition.

The etch back of the sacrificial layer 22 may be realized by any suitable isotropic etching process, wet or dry. The liner layer 21 may be used for etch-stop detection, however a timed etch back is also possible.

The etch back of the liner layer 21 may be realized by any suitable isotropic etching process, wet or dry. Here, the inter-gate spacer layers 12 may be used for etch-stop detection, however a timed etch back is also possible. As the liner layer 21 typically is deposited to define a relatively thin layer (e.g., 2 nm or less), it is envisaged that a relatively brief etch step may suffice to remove the exposed portions of the liner layer 21.

In Fig. 8, the discrete sacrificial layer portions 22a has been removed from the recessed areas 18, thus exposing the discrete liner layer portions 21a in the recessed areas 18. The sacrificial layer portions 22a may be removed using any suitable isotropic etching process, wet or dry, such as a same etching processed used during the etch back of the sacrificial layer 22 discussed with reference to Fig. 6.

In Fig. 9, a discrete charge trap layer 24 has been formed in each recessed area 18. Each charge trap layer 24 is deposited on a respective discrete liner layer portion 21a. The charge trap layers 24 are formed by an ASD process using the discrete liner layer portions 21a as a seeding layer. Thus, charge trap material may be deposited selectively in the recessed areas 18, seeding from (nucleating on) the discrete liner layer portions 21a therein.

The deposition of the charge trap material may be continued until discrete portions of charge trap material of a target thickness have been deposited in the recessed areas 18, each portion defining a respective discrete charge trap layer 24. During the ASD, the inter-gate spacer layers 12 define deposition-inhibiting (non-growth) areas while the liner layer portions 21a define deposition-promoting (seeding) areas for the charge trap material.

The charge trap material may comprise or be silicon nitride (SiN, i.e. Si₃N₄). Silicon nitride represents an efficient and rational realization of charge trap memory cells. Silicon nitride may for instance be deposited by ASD onto any of the above-mentioned examples of liner materials (metal oxides or metal nitrides such as AlOₓ, HfOₓ, TiN, TiO₂). More generally, the charge trap material may be or comprise silicon, meaning that the charge trap layers 24 may be silicon-comprising layers. The charge trap material may for example be silicon, meaning that the charge trap layers 24 may comprise or be silicon layers. Composite layer structures of the charge trap layers 24 are also possible. For example, the charge trap layers 24 may comprise first and second sequentially deposited layers (sub-layers), wherein the first sub-layer is a silicon or silicon-comprising layer, and the second sub-layer is a metal layer such as TiN or Ru. It is envisaged that the present method is compatible also with other choices of charge trap material, as long as they may be deposited in an area-selective fashion on the liner layer portions 21a in the recessed areas 18. The charge trap material may be deposited using any suitable deposition process, conformal or non-conformal, such as an ALD or CVD process.

To facilitate the ASD of the charge trap material, the layer stack 10 may be subjected to a treatment process prior to depositing the charge trap material, to define growth areas in the recessed areas 18 (e.g., on the liner layer portions 21a) and non-growth areas outside the recessed areas 18. The treatment process may be adapted to (further) functionalize the liner layer portions 21a with respect to the ASD of the charge trap material. The treatment process may additionally or alternatively be adapted to passivate exposed surface portions of the inter-gate spacer layers 12 with respect to the ASD of the charge trap material. Thereafter the charge trap material may be deposited selectively on the growth areas in the recessed areas 18. The examples of functionalization and passivation discussed above with reference to ASD of blocking oxide material apply correspondingly to ASD of charge trap material. As a specific non-limiting example, a SiO₂ surface may be passivated by DMA-TMS inhibition selectively to either TiO₂ or TiN.

The discrete charge trap layers 24 may each be formed with a lateral thickness (along the X axis) in a range of 4-8 nm. More generally, the discrete charge trap layers 24 may be formed so as to completely fill the remaining interior spaces of the recessed areas 18. End surfaces of the discrete charge trap layers 24 facing the memory hole 4 may thus become substantially flush with the end surfaces of the inter-gate space layers 12 facing the memory hole 4. In other words, a sidewall of the memory hole 4 may (e.g., again) be restored to a substantially straight profile, or at least with a reduced topography compared prior to forming the charge trap layers 24.

Thus, at the stage of the process illustrated in Fig. 9, each recessed areas 18 has been provided with (e.g., "re-filled" and/or "re-grown" with) a discrete blocking layer 20, a liner layer portion 21a and a charge trap layer 24. These layers define a lateral memory stack for a respective gate layer 14.

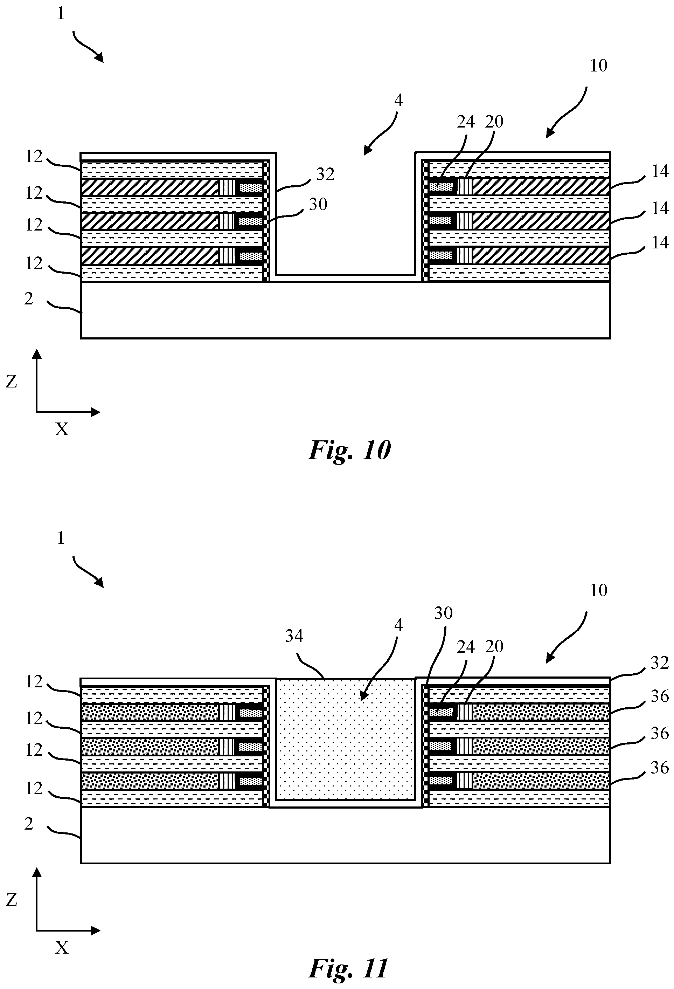

In Fig. 10, a tunneling oxide layer 30, and subsequently a channel layer 32, have been formed in the memory hole 4, along the sidewall thereof. The tunneling oxide layer 30 is thus formed along the discrete charge trap layers 24 of the lateral memory stacks, more specifically along or in contact with the respective inner end surfaces of the charge trap layers 24 facing the memory hole 4. The tunneling oxide layer 30 and the channel layer 32 may each be conformally deposited, e.g. using a respective ALD process. After depositing the tunneling oxide layer 30, the tunneling oxide layer 30 may be subjected to an anisotropic etch oriented top-down (opposite the direction of the Z-axis) to remove portions of the tunneling oxide layer 30 deposited on horizontally oriented surfaces of the structure 1.

The tunneling oxide layer 30 may be formed of any material conventionally used in the industry for tunneling oxide layers, one non-limiting example being SiON. The channel layer 32 may similarly be formed by any suitable channel material conventionally used in the industry for channel layers, typically a semiconductor material such as Si, SiGe or Ge. While not shown in Fig. 10, the channel layer 32 may present an extension outside of the illustrated portion of the structure 1, to facilitate connection to peripheral semiconductor devices and circuitry, such as select transistors.

Subsequently, the memory hole 4 may be filled with a plug or filler material 34, such as an inter-layer dielectric (e.g., SiO₂) or other low-k dielectric. If the gate layers 14 are sacrificial gate layers, the method may as further shown proceed with replacing the sacrificial gate layers 14 by replacement metal gate layers or stacks 36. The sacrificial gate layers 14 may be removed by etching back the sacrificial gate layers 14 from a second hole (e.g., an "access trench", not shown) in the layer stack 10 (e.g. denoting the memory hole 4 as a front side hole or opening the second hole may be referred to as a backside hole or opening). The thusly formed laterally/radially extending gate cavities formed at the levels of the sacrificial gate layers 14 may subsequently be filled with a RMG layer or stack, replacing the sacrificial gate layers 14. The gate cavities may be etched using an isotropic etching process. For example, the gate cavities may be etched using a same type of etching process as used to form the recessed areas 18.

The RMG process may comprise depositing one or more conductive layers, e.g. metal such as one or more of TiN and W. The deposition of the conductive layer(s) may be preceded by deposition of a (conformal) high-k gate dielectric.

Thus, at the stage of the process illustrated in Fig. 11, a memory structure 1 comprising, for each gate level, a discrete blocking layer 20 and a discrete charge trap layer 24. These layers define a lateral memory stack between a respective gate layer/stack 36 and the (shared) tunnel barrier and channel layers 30, 32.

The process may further proceed with conventional process steps of 3D NAND fabrication, as per se is known in the art. For example, the structure 1 may be further processed to contact each gate layer 14/36 to peripheral semiconductor devices and circuitry, such as select transistors and wordline drivers. Contact formation may for example be preceded with patterning the gate layers 14/36 into a staircase structure

The person skilled in the art realizes that the present invention by no means is limited to the embodiments described above. On the contrary, many modifications and variations are possible within the scope of the appended claims.

## Claims

1. A method for forming a memory structure (1) for a 3D NAND flash memory, the method comprising:
forming a layer stack (10) over a substrate (2), the layer stack (10) comprising an alternating sequence of gate layers (14) and inter-gate spacer layers (12);
forming recessed areas (18) in a sidewall surrounding a memory hole (4) in the layer stack (10) by laterally etching back the gate layers (14) relative to the inter-gate spacer layers (12) from the memory hole (4);
forming a discrete blocking oxide layer (20) in each recessed area (18), wherein a thickness of each blocking oxide layer (20) in a lateral direction is less than a depth of each recessed area (18) in the lateral direction;
conformally depositing a continuous liner layer (21) on exposed surfaces in the memory hole (4), wherein the liner layer (21) covers the blocking oxide layer (20) in each recessed area (18);
depositing a continuous sacrificial layer (22) on the liner layer (21);
etching back the sacrificial layer (22) such that the liner layer (21) is exposed outside the recessed areas (18) and discrete portions (22a) of the sacrificial layer (22) remain in the recessed areas (18);
removing exposed portions of the liner layer (21) while using the discrete sacrificial layer portions (22a) as an etch mask such that discrete portions (21a) of the liner layer (21) covered by the discrete sacrificial layer portions (22a) remain in the recessed areas (18);
removing the discrete sacrificial layer portions (22a) in the recessed areas (18);
forming a discrete charge trap layer (24) in each recessed area (18), wherein each charge trap layer (24) is deposited on the discrete liner layer portion (21a) remaining in each recessed area (18) by a first area-selective deposition process while using the discrete liner layer portion (21a) as a seeding layer;
subsequent to forming the charge trap layers (24), depositing a tunneling oxide layer (30) in the memory hole (4); and
depositing a channel layer (32) on the tunneling oxide layer (30).

2. The method according to claim 1, wherein the discrete blocking oxide layer (20) is deposited on the etched-back gate layer (14) in each recessed area (18) by a second area-selective deposition process.

3. The method according to claim 1, wherein the discrete blocking oxide layer (20) is formed by oxidizing a portion (14b) of the etched-back gate layer (14) in each recessed area (18), such that the oxidized portion (14b) forms the discrete blocking oxide layer (20) on a non-oxidized portion (14a) of the etched-back gate layer (14).

4. The method according to claim 3, wherein the portions (14b) of the etched-back gate layer (14) are oxidized by a thermal oxidation process or a plasma oxidation process.

5. The method according to any one of the preceding claims, wherein the liner layer (21) comprises a metal oxide or a metal nitride.

6. The method according to any one of the preceding claims, wherein the sacrificial layer (22) is deposited to completely fill a remaining space in each recessed area (18).

7. The method according to any one of the preceding claims, wherein the charge trap layer (21) is a silicon-comprising layer, such as a silicon nitride layer.

8. The method according to any one of the preceding claims, wherein the discrete blocking oxide layer (20) in each recessed area (18) is formed with a lateral thickness in a range of 4-12 nm.

9. The method according to any one of the preceding claims, wherein the discrete charge trap layer (24) is formed with a lateral thickness in a range of 4-8 nm.

10. The method according to any one of the preceding claims, wherein the liner layer (21) is formed with a thickness of 2 nm or less.

11. The method according to any one of the preceding claims, wherein the inter-gate spacer layers (12) and the gate layers (14) are formed with respective layer thicknesses in a range of 5-25 nm.

12. The method according to claim 11, wherein a combined thickness of one inter-gate spacer layer (12) and one gate layer (14) is 45 nm or less.

13. The method according to any one of the preceding claims, wherein the gate layers (14) are sacrificial gate layers and the method further comprises, subsequent to forming the charge trap layers (24), replacing the sacrificial gate layers (14) by a replacement metal gate layer (36).

14. The method according to claim 13, wherein the replacement metal gate layer (36) is formed subsequent to depositing the tunneling oxide layer (30) and the channel layer (32).
